# EUROPÄISCHE PATENTSCHRIFT

(11) **EP 3 002 583 B1**
(45) Veröffentlichungstag und Bekanntmachung des Hinweises auf die Patenterteilung: **28.02.2018**
(21) Anmeldenummer: 15002345.5
(22) Anmeldetag: 06.08.2015
(51) Int. Cl.: G01N 27/90, G01R 33/14, G01N 27/80

(54) **VERFAHREN UND VORRICHTUNG ZUR WIRBELSTROMPRÜFUNG MIT IMPULSMAGNETISIERUNG**
METHOD AND DEVICE FOR EDDY CURRENT TESTING WITH IMPULSE MAGNETIZATION
PROCÉDÉ ET DISPOSITIF POUR LA VÉRIFICATION DU COURANT DE FOUCAULT DANS UNE MAGNETISATION A IMPULSION

(30) Priorität: 30.09.2014 DE 102014114226
(43) Veröffentlichungstag der Anmeldung: 06.04.2016
(73) Patentinhaber: Rohmann GmbH, 67227 Frankenthal (DE)
(72) Erfinder: Gopalan, Aschwin, 67245 Lambsheim (DE); Rother, Mathias, 76646 Bruchsal (DE); Schneibel, Gerald, 68623 Lampertheim (DE)
(74) Vertreter: Patent- und Rechtsanwälte Ullrich & Naumann

(56) Entgegenhaltungen:
- EP-A2- 1 116 952
- EP-B1- 0 100 009
- WO-A1-2010/138093
- DE-C2- 3 037 932
- US-A- 6 037 768

## Beschreibung

Die Erfindung betrifft ein Verfahren und eine Vorrichtung zur zerstörungsfreien elektromagnetischen Prüfung eines Prüfkörpers aus ferromagnetischem Material mit einem Elektromagneten, der ein U-förmiges oder V-förmiges Joch mit zu dem Prüfkörper hin weisenden Jochschenkeln und wenigstens eine Feldwicklung hat, die mit einem periodischen bipolaren elektrischen Erregersignal gespeist ist, um den Prüfkörper, dessen Hysteresekurve durchfahrend, periodisch umzumagnetisieren, und mit einer zwischen den Jochschenkeln angeordneten Wirbelstromprüfsonde, die ein magnetisches Wechselfeld zu erzeugen und elektromagnetische Eigenschaften des Prüfkörpers zu detektieren geeignet ist, wobei das Erregersignal des Elektromagneten gepulst ist.

Ein Verfahren und eine Vorrichtung dieser Art sind aus der DE 30 37 932 C2 bekannt. Der Elektromagnet ist hier mit Wechselstrom gespeist. Die Frequenz, mit der die Hysterese durchfahren wird, beträgt weniger als 10³ s⁻¹. Die Wirbelstrommeßfrequenz ist daran angepaßt und liegt zwischen 5 x 10⁴ und 10⁶ s⁻¹.

Bei der EP 0 100 009 B1 wird der Elektromagnet aus einem bipolaren Netzgerät mit sägezahnförmigem Strom gespeist, um die Hysteresekurve mit einer Frequenz zwischen 10⁻¹ und 10³ s⁻¹ zu durchfahren. Die Wirbelstrommeßfrequenz ist wesentlich höher. Durch Verstellen der Wirbelstrommeßfrequenz läßt sich eine Aussage nicht nur über die Härte des Prüfkörpers, sondern auch darüber treffen, wie dick eine gehärtete Deckschicht des Prüfkörpers ist.

Bei der DE 10 2005 046 574 B4 ist der periodische Erregerstrom des Elektromagneten ausdrücklich als sinusförmig bezeichnet. In Abhängigkeit von der Impedanz des Elektromagneten ergeben sich Ummagnetisierungsfrequenzen von 10 bis 2,4 x 10⁴ s⁻¹.

Die WO 2010/138 093 A1 betrifft ein Prüfverfahren, das als "magnetic tape testing" bezeichnet wird. Auf einen Prüfkörper aus elektrisch leitfähigem, im allgemeinen nicht ferromagnetischen Material wird ein Streifen Magnetband aufgelegt. Mit einem Induktor werden Wirbelströme in dem Prüfkörper induziert. Den Wirbelstromverlauf beeinflussende Defekte im weitesten Sinn werden anhand der Aufzeichnung auf dem Magnetband detektiert.

Der Induktor der WO 2010/138 093 A1 kann mit bipolaren Rechteckpulsen betrieben werden. Das wird mit Energieersparnis und der Vermeidung übermäßiger Erwärmung begründet. Die halbe Periode t₂ der Rechteckpulse beträgt 0,1 bis 0,4 Mikrosekunden. Die Pulsfolgefrequenz 1/ti beträgt 10³ s⁻¹. Daraus ergibt sich ein Tastgrad t₂/t₁ von 1 bis 4 x 10⁻⁴.

Die US 6 037 768 A betrifft ein mobiles Wirbelstromprüfgerät, das mit einer Rechteckspannung gespeist wird.

In der EP 1 116 952 A2 ist die Verwendung von Magnetfeldsensoren zur berührungslosen Kontrolle von Metallbändern im Zuge des Durchlaufens von Bandprozesslinien oder Walzwerken beschrieben.

Aufgabe der Erfindung ist es, die Signifikanz der zerstörungsfreien Härteprüfung eines Prüfkörpers aus ferromagnetischem Material zu verbessern, das Parameterspektrum der Prüfung zu erweitern und eine Selbstüberwachung der Prüfung zu eröffnen - all das bei vermindertem Energiebedarf, von besonderer Wichtigkeit bei der mobilen Prüfung.

In verfahrensmäßiger Hinsicht ist diese Aufgabe erfindungsgemäß dadurch gelöst, dass das Erregersignal des Elektromagneten aus einer periodischen Folge wiederkehrender bipolarer, rechteckiger Impulse besteht, deren Impulsdauer (ti) klein gegen die Periodendauer (tᵣ) der Impulsfolge ist, so dass der Tastgrad ti / tᵣ weniger als 0,2 beträgt.

In vorrichtungsmäßiger Hinsicht ist die Aufgabe erfindungsgemäß gelöst durch eine FET-Vollbrückenschaltung, die das Erregersignal des Elektromagneten als aus einer periodischen Folge wiederkehrender bipolarer, rechteckiger Impulse bestehend erzeugt, deren Impulsdauer (ti) klein gegen die Periodendauer (tᵣ) der Impulsfolge ist, so dass der Tastgrad ti / tᵣ weniger als 0,2 beträgt.

Dank der kurzen Impulsdauer ti ist der Energiebedarf der erfindungsgemäßen Wirbelstromprüfung mit Impulsmagnetisierung gering. Das Erregersignal hat zwischen den Impulsen lange Intervalle auf dem Potential Null. In diesen Intervallen können zusätzliche Prüf- und Kontrollmessungen durchgeführt werden, beispielsweise um den Meßabstand zum Prüfkörper im Sinn einer Selbstüberwachung der Prüfapparatur zu kontrollieren.

Ein Elektromagnet mit einem U-förmigen oder V-förmigen Joch wird verwendet, damit sich das Magnetfeld an den Jochschenkeln konzentriert und die Wirbelstromprüfsonde in einem annähernd magnetfeldfreien Bereich mittig zwischen den Jochschenkeln positioniert werden kann. Eine Justierung kann mit dem Leerlaufsignal der Wirbelstromprüfsonde erfolgen. Elektromagnete anderer Bauart, die diese Besonderheit nicht bieten, beispielsweise Elektromagnete mit Ringkern, sind für die Erfindung weniger geeignet.

Die Erfindung hat eine bevorzugte Anwendung für die Härteprüfung von Stahlblech. Gewalztes Stahlblech hat an der Oberfläche eine recht inhomogene Walzhaut, die bei der herkömmlichen Wirbelstromprüfung störeinflußträchtig ist. Die Walzhaut vor der Prüfung durch Strahlen zu entfernen, ist aufwändig und nicht immer praktikabel. Durch die erfindungsgemäße Impulsmagnetisierung bei der Wirbelstromprüfung werden Walzhaut- und andere Oberflächeneffekte ausgeblendet und sogenannte "Hard spots" (lokale Verhärtungen) im Blech verläßlich erkannt. Das eröffnet nicht zuletzt der inline Prüfung im Walzwerk bemerkenswerte Perspektiven.

Bei einer bevorzugten Ausführungsform hat ein jeder Impuls des Erregersignals eine vom Potential Null ansteigende Flanke, ein Plateau auf positivem Potential, eine zum Potential Null und darüber hinweg abfallende Flanke, ein Plateau auf negativem Potential und eine zum Potential Null wieder ansteigende Flanke. Es versteht sich, dass die Potentiale positiv und negativ austauschbar sind. Genauso kann der zeitliche Impulsverlauf vorwärts wie rückwärts betrachtet werden.

Bei einer bevorzugten Ausführungsform sind die Plateaus der Impulse von betragsmäßig gleichem Potential (Vᵢ) und von zeitlich gleicher Dauer. Die Ummagnetisierung des Prüfkörpers erfolgt so hin- und hergehend mit gleicher Energie.

Bei einer bevorzugten Ausführungsform sind die Flanken der Impulse linear und gleich steil.

Bei einer bevorzugten Ausführungsform hat die Wirbelstromprüfsonde eine Erregerspule zur Erzeugung des magnetischen Wechselfelds und eine Detektionsspule zur Erfassung der Überlagerungspermeabilität des Prüfkörpers. Die Wirbelstromprüfsonde kann aber auch eine parametrische Spule haben, die die Funktionen der Erregerspule und Detektionsspule in sich vereint.

Bei einer bevorzugten Ausführungsform ist das Erregersignal des Elektromagneten mit 10 bis 200 s⁻¹ gepulst und die Wirbelstromprüfsonde mit 5 x 10⁴ bis 2 x 10⁵ s⁻¹ betrieben.

Bei einer bevorzugten Ausführungsform ist das Wechselfeld der Wirbelstromprüfsonde mit dem Erregersignal des Elektromagneten synchronisiert.

Der geringe Energiebedarf der erfindungsgemäßen Impulsmagnetisierung ist von besonderer Bedeutung für eine mobile Prüfung, bei der die Energieversorgung aus einem Akkumulator oder einer Batterie erfolgt.

Eine weitere bevorzugte Anwendung hat die Erfindung für den inline Prüfbetrieb in einem Walzwerk.

Die Erfindung wird im folgenden anhand eines in der Zeichnung dargestellten Ausführungsbeispiels näher erläutert. Es zeigen:
- Fig. 1: schematisch einen Prüfaufbau; und
- Fig. 2: ein Spannungs-Zeit-Diagramm.

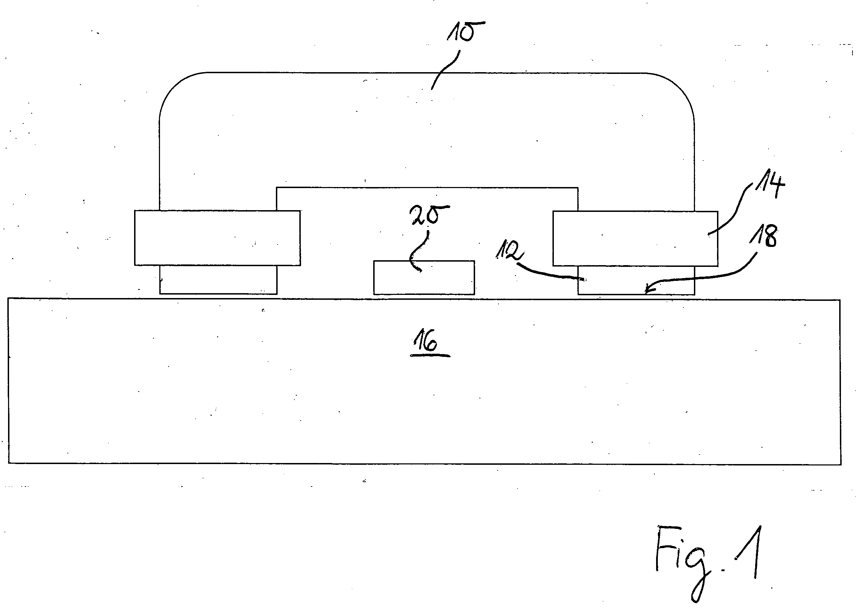

Fig. 1 zeigt den Prüfaufbau mit einem Elektromagneten, der ein U-förmiges Magnetjoch 10 hat. Um die Jochschenkel 12 liegt je eine Feldwicklung 14 herum. Die Feldwicklungen 14 sind elektrisch in Reihe geschaltet.

Ein Prüfkörper 16 aus ferromagnetischem Material liegt den Stirnflächen 18 der Jochschenkel 12 in geringem Abstand gegenüber.

Der Abstand wird durch einen Gleitschuh aus elektrischem Isoliermaterial konstant eingehalten.

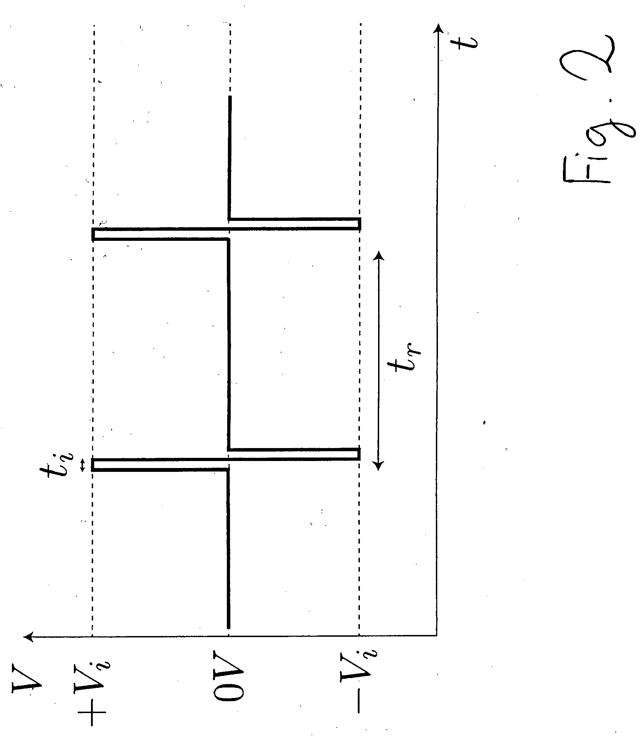

Zwischen den Jochschenkeln 12 befindet sich in mittiger Anordnung eine Wirbelstromprüfsonde 20, die mit hochfrequentem Wechselstrom betrieben wird. An den Feldwicklungen 14 des Elektromagneten liegt das in Fig. 2 dargestellte Erregersignal an.

Die Wirbelstromprüfsonde 20 ist ein Absolutsensor in Sender-Empfänger-Anordnung ohne Kernsystem. Sie hat eine Erregerspule und eine Detektionsspule jeweils in Form einer Luftspule ohne weichmagnetischen Kern. Die Wirbelstromprüfsonde 20 ist zwischen den Jochschenkeln 12 des Magnetisierungsjochs 10 zentrisch angebracht. Die der Impulsmagnetisierung dienenden beiden Feldwicklungen 14 sind auf die Jochschenkel 12 aufgebracht. Die Wirbelstromprüfsonde 20 schließt in etwa bündig mit den Enden des Joches 10 ab. Mechanisch wird der Abstand zwischen Sensor und Prüfkörper 16 auf ca. 2 mm bis 3 mm eingestellt. Dieser Abstand ist kritisch und darf während der Prüfung nicht verändert werden.

Die Impulsmagnetisierung wird von einer schnellen FET-Vollbrückenschaltung angesteuert. Mit einer einstellbaren Rate von 100 bis 200 Impulsen pro Sekunde wird die Feldwicklung 14 des Joches 10 abwechselnd mit + 24 V und - 24 V belegt. Die Zeitdauer ti der Impulse kann ebenfalls eingestellt werden. Die Impulserzeugung erfolgt synchron mit der Erfassung der Meßergebnisse mittels der Wirbelstromprüfsonde 20, d. h. die Umschaltung erfolgt immer in der gleichen Phase bezogen auf die Prüffrequenz des Wirbelstromkanals.

Die Wirbelstromprüfsonde 20 wird an einem normalen Wirbelstrom-Prüfkanal betrieben. Die Prüffrequenz beträgt ca. 8 x 10⁴ s⁻¹. Das Signal wird mit einem Bandpass gefiltert. Dieser unterdrückt effektiv das Signal, das außerhalb der Impulse gemessen wird. Dies entspricht einer laufenden Kompensation des Signales in den Messpausen. Während eines Ummagnetisierungsimpulses wird ein mehr oder minder großes Signal im Wirbelstromkanal erzeugt. Die Amplitude dieses Signals wird zur Auswertung herangezogen.

Der Ummagnetisierungsimpuls bewirkt das Durchlaufen eines Teils der Hysteresekurve des Prüfkörpermaterials. Die Wirbelstromprüfsonde 20 mißt dabei die Veränderung der Permeabilität des Prüfkörpers 16. Je "magnetisch härter" das Material, je höher also seine magnetische Koerzitivfeldstärke ist, desto kleiner ist der Impuls, den der Wirbelstromsensor detektiert.

Die Wirbelstromprüfung mit Impulsmagnetisierung ist besonders geeignet, Gefügeunterschiede an ferromagnetischen gewalzten Stahlblechen zu detektieren. Verglichen mit einer Wirbelstromprüfung ohne Impulsmagnetisierung ergeben sich folgende Vorteile:
- Das Verfahren zeigt eine größere Unempfindlichkeit gegen Störsignale von der Walzhaut.
- Da es sich um ein dynamisches Prüfverfahren handelt, ist es nicht notwendig, das System auf dem "guten" Blechabschnitt zu kompensieren.
- Durch die abwechselnde schnelle Ummagnetisierung bleiben keine Späne am Magnetjoch 10 hängen, und der Prüfkörper 16 wird tief aufmagnetisiert.

Zur Detektion sogenannter "Hard spots" von gewalzten Stahlblechen nutzt man aus, dass deren lokal erhöhte mechanische Härte mit erhöhter magnetischer Härte korreliert.

## Patentansprüche

1. Verfahren zur zerstörungsfreien elektromagnetischen Prüfung eines Prüfkörpers (16) aus ferromagnetischem Material mit einem Elektromagneten, der ein U-förmiges oder V-förmiges Joch (10) mit zu dem Prüfkörper (16) hin weisenden Jochschenkeln (12) und wenigstens eine Feldwicklung (14) hat, die mit einem periodischen bipolaren elektrischen Erregersignal gespeist ist, um den Prüfkörper (16), dessen Hysteresekurve durchfahrend, periodisch umzumagnetisieren, und mit einer zwischen den Jochschenkeln (12) angeordneten Wirbelstromprüfsonde (20), die ein magnetisches Wechselfeld zu erzeugen und elektromagnetische Eigenschaften des Prüfkörpers (16) zu detektieren geeignet ist, wobei das Erregersignal des Elektromagneten gepulst ist,
**dadurch gekennzeichnet,dass** das Erregersignal des Elektromagneten aus einer periodischen Folge wiederkehrender bipolarer, rechteckiger Impulse besteht, deren Impulsdauer (tᵢ) klein gegen die Periodendauer (tᵣ) der Impulsfolge ist, so dass der Tastgrad tᵢ / tᵣ weniger als 0,2 beträgt.

2. Verfahren nach Anspruch 1, **dadurch gekennzeichnet, dass** ein jeder Impuls eine vom Potential Null ansteigende Flanke, ein Plateau auf positivem Potential, eine zum Potential Null und darüber hinweg abfallende Flanke, ein Plateau auf negativem Potential und eine zum Potential Null wieder ansteigende Flanke hat.

3. Verfahren nach Anspruch 2, **dadurch gekennzeichnet, dass** die Plateaus von betragsmäßig gleichem Potential (Vᵢ) und von zeitlich gleicher Dauer sind.

4. Verfahren nach Anspruch 2 oder 3, **dadurch gekennzeichnet, dass** die Flanken linear und gleich steil sind.

5. Verfahren nach einem der Ansprüche 1 bis 4, **dadurch gekennzeichnet, dass** das Erregersignal des Elektromagneten mit 10 bis 200 s⁻¹ gepulst und die Wirbelstromprüfsonde (20) mit 5 x 10⁴ bis 2 x 10⁵ s⁻¹ betrieben ist.

6. Verfahren nach einem der Ansprüche 1 bis 5, **dadurch gekennzeichnet, dass** das Wechselfeld der Wirbelstromprüfsonde (20) mit dem Erregersignal des Elektromagneten synchronisiert ist.

7. Verfahren nach einem der Ansprüche 1 bis 6 für den inline Prüfbetrieb in einem Walzwerk.

8. Vorrichtung zur zerstörungsfreien elektromagnetischen Prüfung eines Prüfkörpers (16) aus ferromagnetischem Material mit einem Elektromagneten, der ein U-förmiges oder V-förmiges Joch (10) mit zu dem Prüfkörper (16) hin weisenden Jochschenkeln (12) und wenigstens eine Feldwicklung (14) hat, die mit einem periodischen bipolaren elektrischen Erregersignal gespeist ist, um den Prüfkörper (16), dessen Hysteresekurve durchfahrend, periodisch umzumagnetisieren, und mit einer zwischen den Jochschenkeln (12) angeordneten Wirbelstromprüfsonde (20), die ein magnetisches Wechselfeld zu erzeugen und elektromagnetische Eigenschaften des Prüfkörpers (16) zu detektieren geeignet ist, wobei das Erregersignal des Elektromagneten gepulst ist,
**gekennzeichnet durch** eine FET-Vollbrückenschaltung, die das Erregersignal des Elektromagneten als aus einer periodischen Folge wiederkehrender bipolarer, rechteckiger Impulse bestehend erzeugt, deren Impulsdauer (tᵢ) klein gegen die Periodendauer (tᵣ) der Impulsfolge ist, so dass der Tastgrad tᵢ / tᵣ weniger als 0,2 beträgt.

9. Vorrichtung nach Anspruch 8, **dadurch gekennzeichnet, dass** ein jeder Impuls eine vom Potential Null ansteigende Flanke, ein Plateau auf positivem Potential, eine zum Potential Null und darüber hinweg abfallende Flanke, ein Plateau auf negativem Potential und eine zum Potential Null wieder ansteigende Flanke hat.

10. Vorrichtung nach Anspruch 9, **dadurch gekennzeichnet, dass** die Plateaus von betragsmäßig gleichem Potential (Vᵢ) und von zeitlich gleicher Dauer sind.

11. Vorrichtung nach einem der Ansprüche 8 bis 10, **dadurch gekennzeichnet, dass** die Wirbelstromprüfsonde (20) eine Erregerspule zur Erzeugung des magnetischen Wechselfelds und eine Detektionsspule zur Erfassung der Überlagerungspermeabilität des Prüfkörpers (16) hat.

12. Vorrichtung nach einem der Ansprüche 8 bis 11, **dadurch gekennzeichnet, dass** die Wirbelstromprüfsonde (20) eine parametrische Spule hat.

13. Vorrichtung nach einem der Ansprüche 8 bis 12, **dadurch gekennzeichnet, dass** das Erregersignal des Elektromagneten mit 10 bis 200 s⁻¹ gepulst und die Wirbelstromprüfsonde (20) mit 5 x 10⁴ bis 2 x 10⁵ s⁻¹ betrieben ist.

14. Vorrichtung nach einem der Ansprüche 8 bis 13, **dadurch gekennzeichnet, dass** das Wechselfeld der Wirbelstromprüfsonde (20) mit dem Erregersignal des Elektromagneten synchronisiert ist.

15. Vorrichtung nach einem der Ansprüche 8 bis 14 für die mobile Prüfung mit Energieversorgung aus einem Akkumulator oder einer Batterie.

## Claims

1. Method for the non-destructive electromagnetic testing of a test member (16) of ferromagnetic material having an electromagnet which has a U-shaped or V-shaped yoke (10) having yoke members (12) which are directed towards the test member (16) and at least one field winding (14) which is supplied with a periodically bipolar electrical exciter signal in order to periodically remagnetise the test member (16) by travelling through the hysteresis curve thereof, and having an eddy current test probe (20) which is arranged between the yoke members (12) and which is suitable for producing a magnetic alternating field and detecting electromagnetic properties of the test member (16), wherein the exciter signal of the electromagnet is pulsed,
**characterised in that** the exciter signal of the electromagnet comprises a periodic sequence of repeated bipolar rectangular pulses whose pulse duration (ti) is small with respect to the period duration (tᵣ) of the pulse sequence so that the duty cycle tᵢ/tᵣ is less than 0.2.

2. Method according to claim 1, **characterised in that** each pulse has a flank which increases from zero potential, a plateau at positive potential, a flank which decreases to zero potential and beyond, a plateau at negative potential and a flank which increases again to zero potential.

3. Method according to claim 2, **characterised in that** the plateaus have the same potential value (Vᵢ) and the same time duration.

4. Method according to claim 2 or 3, **characterised in that** the flanks are linear and are of equal steepness.

5. Method according to any one of claims 1 to 4, **characterised in that** the exciter signal of the electromagnet is pulsed at from 10 to 200 s⁻¹ and the eddy current test probe (20) is operated at from 5 x 10⁴ to 2 x 10⁵ s⁻¹.

6. Method according to any one of claims 1 to 5, **characterised in that** the alternating field of the eddy current test probe (20) is synchronised with the exciter signal of the electromagnet.

7. Method according to any one of claims 1 to 6 for the inline test operation in a rolling mill.

8. Device for the non-destructive electromagnetic testing of a test member (16) of ferromagnetic material having an electromagnet which has a U-shaped or V-shaped yoke (10) having yoke members (12) which are directed towards the test member (16) and at least one field winding (14) which is supplied with a periodically bipolar electrical exciter signal in order to periodically remagnetise the test member (16) by travelling through the hysteresis curve thereof, and having an eddy current test probe (20) which is arranged between the yoke members (12) and which is suitable for producing a magnetic alternating field and detecting electromagnetic properties of the test member (16), wherein the exciter signal of the electromagnet is pulsed,
**characterised by** a FET full bridge circuit which produces the exciter signal of the electromagnet as comprising a periodic sequence of repeated bipolar rectangular pulses whose pulse duration (ti) is small with respect to the period duration (tᵣ) of the pulse sequence so that the duty cycle tᵢ/tᵣ is less than 0.2.

9. Device according to claim 8, **characterised in that** each pulse has a flank which increases from zero potential, a plateau at positive potential, a flank which decreases to zero potential and beyond, a plateau at negative potential and a flank which increases again to zero potential.

10. Device according to claim 9, **characterised in that** the plateaus have the same potential value (Vᵢ) and the same time duration.

11. Device according to any one of claims 8 to 10, **characterised in that** the eddy current test probe (20) has an exciter coil for producing the magnetic alternating field and a detection coil for detecting the incremental permeability of the test member (16).

12. Device according to any one of claims 8 to 11, **characterised in that** the eddy current test probe (20) has a parametric coil.

13. Device according to any one of claims 8 to 12, **characterised in that** the exciter signal of the electromagnet is pulsed at from 10 to 200 s⁻¹ and the eddy current test probe (20) is operated at from 5 x 10⁴ to 2 x 10⁵ s⁻¹.

14. Device according to any one of claims 8 to 13, **characterised in that** the alternating field of the eddy current test probe (20) is synchronised with the exciter signal of the electromagnet.

15. Device according to any one of claims 8 to 14 for mobile testing with energy supply from an accumulator or a battery.

## Revendications

1. Procédé de contrôle électromagnétique non destructeur d'un échantillon (16) constitué de matériau ferromagnétique avec un électro-aimant, qui comprend un étrier (10) en forme de U ou en forme de V, avec des branches d'étrier (12) orientées vers l'échantillon (16) et au moins un enroulement de champ (14), qui est alimenté avec in signal d'excitation électrique bipolaire périodique afin de magnétiser périodiquement l'échantillon (16) en parcourant sa courbe d'hystérésis, et avec une sonde de contrôle à courants de Foucault (20) disposée entre les branches de l'étrier (12), qui est conçue pour générer un champ alternatif et pour détecter des propriétés électromagnétiques de l'échantillon (16), le signal d'excitation de l'électro-aimant étant pulsé,
**caractérisé en ce que** le signal d'excitation de l'électro-aimant est constitué d'une série périodique d'impulsions rectangulaires bipolaires récurrentes, dont la durée d'impulsion (tᵢ) est faible par rapport à la durée de la période (tᵣ) de la série d'impulsions, de façon à ce que le rapport cyclique tᵢ / tᵣ soit inférieur à 0,2.

2. Procédé selon la revendication 1, **caractérisé en ce que** chaque impulsion comprend un flanc montant à partir du potentiel zéro, un palier au niveau d'un potentiel positif, un flanc descendant vers le potentiel zéro et en deçà, un palier au niveau d'un potentiel négatif et un flanc remontant vers le potentiel zéro.

3. Procédé selon la revendication 2, **caractérisé en ce que** les paliers présentent, en valeur absolue, le même potentiel (Vᵢ) et la même durée.

4. Procédé selon la revendication 2 ou 3, **caractérisé en ce que** les flancs sont linéaires et présentent la même pente.

5. Procédé selon l'une des revendications 1 à 4, **caractérisé en ce que** le signal d'excitation de l'électro-aimant est pulsé à 10 à 200 s⁻¹ et la sonde de contrôle à courants de Foucault (20) est actionnée avec 5 x 10⁴ jusqu'à 2 x 10⁵ s⁻¹.

6. Procédé selon l'une des revendications 1 à 5, **caractérisé en ce que** le champ alternatif de la sonde de contrôle à courants de Foucault (20) est synchronisé avec le signal d'excitation de l'électro-aimant.

7. Procédé selon l'une des revendications 1 à 6 pour le contrôle en ligne dans un laminoir.

8. Dispositif pour le contrôle électromagnétique non destructeur d'un échantillon (16) constitué de matériau ferromagnétique avec un électro-aimant, qui comprend un étrier (10) en forme de U ou en forme de V, avec des branches d'étrier (12) orientées vers l'échantillon (16) et au moins un enroulement de champ (14), qui est alimenté avec in signal d'excitation électrique bipolaire périodique afin de magnétiser périodiquement l'échantillon (16) en parcourant sa courbe d'hystérésis, et avec une sonde de contrôle à courants de Foucault (20) disposée entre les branches de l'étrier (12), qui est conçue pour générer un champ alternatif et pour détecter des propriétés électromagnétiques de l'échantillon (16), le signal d'excitation de l'électro-aimant étant pulsé,
**caractérisé par** un circuit en pont complet FET qui génère le signal d'excitation de l'électro-aimant sous la forme d'une série périodique d'impulsions rectangulaires bipolaires récurrentes dont la durée d'impulsion (tᵢ) est faible par rapport à la durée de période (tᵣ) de la série d'impulsions, de façon à ce que le rapport cyclique tᵢ / tᵣ soit inférieur à 0,2.

9. Dispositif selon la revendication 8, **caractérisé en ce que** chaque impulsion comprend un flanc montant à partir du potentiel zéro, un palier au niveau d'un potentiel positif, un flanc descendant vers le potentiel zéro et en deçà, un palier au niveau d'un potentiel négatif et un flanc remontant vers le potentiel zéro.

10. Dispositif selon la revendication 9, **caractérisé en ce que** les paliers présentent, en valeur absolue, le même potentiel (Vᵢ) et la même durée.

11. Dispositif selon l'une des revendications 8 à 10, **caractérisé en ce que** la sonde de contrôle à courants de Foucault (20) comprend une bobine d'excitation pour la génération du champ magnétique alternatif et une bobine de détection pour la mesure de la perméabilité de superposition de l'échantillon (16).

12. Dispositif selon l'une des revendications 8 à 11, **caractérisé en ce que** la sonde de contrôle à courants de Foucault (20) comprend une bobine paramétrique.

13. Dispositif selon l'une des revendications 8 à 12, **caractérisé en ce que** le signal d'excitation de l'électro-aimant est pulsé avec 10 à 200 s⁻¹ et la sonde de contrôle à courants de Foucault (20) avec 5 x 10⁴ jusqu'à 2 x 10⁵ s⁻¹.

14. Dispositif selon l'une des revendications 8 à 13, **caractérisé en ce que** le champ alternatif de la sonde de contrôle à courants de Foucault (20) est synchronisé avec le signal d'excitation de l'électro-aimant.

15. Dispositif selon l'une des revendications 8 à 14, pour le contrôle mobile avec une alimentation en énergie constituée d'un accumulateur ou d'une batterie.
